# EUROPEAN PATENT APPLICATION

(11) **EP 4 693 287 A1**
(43) Date of publication of application: **11.02.2026**
(21) Application number: 24910009.0
(22) Date of filing: 12.09.2024
(51) Int. Cl.: G11C 5/00

(54) **INSTRUCTION SAMPLING CIRCUIT AND MEMORY**

(30) Priority: 29.12.2023 CN 202311872682
(71) Applicant: CXMT Corporation, Hefei City, Anhui Province 230601 (CN)
(72) Inventor: XIE, Yanpeng, Hefei, Anhui 230601 (CN); HUANG, Zequn, Hefei, Anhui 230601 (CN)
(74) Representative: Gulde & Partner
(86) International application number: PCT/CN2024/118470
(87) International publication number: WO 2025/139063

(57) **Abstract**

The present disclosure provides a command sampling circuit and a memory. The command sampling circuit includes a sampling circuit and a delay circuit. The sampling circuit receives a memory command and a sampling clock, samples the memory command separately in response to a first sampling edge and a second sampling edge of the sampling clock, and outputs a first cycle command and a second cycle command; the sampling circuit has a first output end and a second output end; the delay circuit delays a command output at the first output end of the sampling circuit and then outputs a delayed command; a command decoding circuit receives an output clock, decodes the commands output by the sampling circuit, and outputs, in response to an output edge of the output clock, a current decoded result as decoding information of the memory command; an address output circuit receives the output clock and outputs, in response to the output edge, a command currently output at the second output end of the sampling circuit as address information of the memory command. This solution can improve the efficiency of command sampling.

## Description

### CROSS-REFERENCE TO RELATED APPLICATIONS

The present application claims priority to Chinese Patent Application No. 202311872682.0 filed with China National Intellectual Property Administration on December 29, 2023 and entitled "COMMAND SAMPLING CIRCUIT AND MEMORY", the content of which is incorporated herein by reference in its entirety.

### TECHNICAL FIELD

The present disclosure relates to memory technology, and in particular, to a command sampling circuit and a memory.

### BACKGROUND

A dynamic random access memory (DRAM) is a semiconductor memory that writes and reads data randomly at a high speed, and is widely used in data storage devices or apparatuses.

In practical applications, the information of the memory command may need to be sampled separately through multiple cycles, and finally output to the subsequent circuit together. Therefore, there is a need to provide a command sampling circuit to achieve the above purpose.

### SUMMARY

Embodiments of the present disclosure provide a command sampling circuit and a memory.

According to some embodiments, a first aspect of the present disclosure provides a command sampling circuit. The command sampling circuit includes a sampling circuit and a delay circuit. The sampling circuit receives a memory command and a sampling clock, and is configured to sample the memory command separately in response to a first sampling edge and a second sampling edge of the sampling clock, and output a first cycle command and a second cycle command; the sampling circuit has a first output end and a second output end; an input end of the delay circuit is connected to the first output end of the sampling circuit, an output end of the delay circuit is connected to the command decoding circuit, and the delay circuit is configured to delay a command output at the first output end of the sampling circuit and then output a delayed command; a command decoding circuit is coupled to the command sampling circuit, receives an output clock, and is configured to decode the commands output by the sampling circuit and output, in response to an output edge of the output clock, a current decoded result as decoding information of the memory command; the second output end of the sampling circuit is connected to an address output circuit; the address output circuit receives the output clock and is configured to output, in response to the output edge, a command currently output at the second output end of the sampling circuit as address information of the memory command.

In some examples, the delay circuit includes an even number of inverters.

In some examples, the output edge of the output clock is located at the second sampling edge, or is located after the second sampling edge and has a preset delay amount relative to the second sampling edge, the delay amount satisfying a timing requirement required for sampling at the output edge.

In some examples, the sampling circuit and the command decoding circuit both include a flip-flop; the delay amount includes a setup time of the flip-flop in the command decoding circuit and a hold time of the flip-flop in the sampling circuit.

In some examples, the delay amount is not greater than a difference between a time that elapsed between the first sampling edge and the second sampling edge and the setup time of the flip-flop in the command decoding circuit.

In some examples, the sampling clock includes an odd clock and an even clock; the sampling circuit includes: a first sampling sub-circuit and a second sampling sub-circuit, the first sampling sub-circuit having a first even output end and a second even output end, and the second sampling sub-circuit having a first odd output end and a second odd output end; an input end of the first sampling sub-circuit is connected to an input end of the second sampling sub-circuit for receiving the memory command; a clock end of the first sampling sub-circuit receives the even clock, and a clock end of the second sampling sub-circuit receives the odd clock; the delay circuit includes: a first delay sub-circuit and a second delay sub-circuit, the first even output end being connected to an input end of the first delay sub-circuit, and the first odd output end being connected to an input end of the second delay sub-circuit; output ends of the first delay sub-circuit and the second delay sub-circuit, and the second even output end and the second odd output end are connected to the command decoding circuit; the second even output end and the second odd output end are connected to the address output circuit.

In some examples, the command decoding circuit includes a decoding circuit and a decoding output circuit; an input end of the decoding circuit is connected to the output ends of the first delay sub-circuit and the second delay sub-circuit, and the second even output end and the second odd output end, an output end of the decoding circuit is connected to the decoding output circuit, and the decoding circuit is configured to perform decoding processing; the decoding output circuit receives the output clock and is configured to output, in response to the output edge, a decoded result currently output by the decoding circuit as the decoding information of the memory command.

In some examples, the decoding circuit includes: a first decoding circuit corresponding to a 1N mode and a second decoding circuit corresponding to a 2N mode; an input end of the first decoding circuit is connected to the second even output end and the second odd output end, an output end of the first decoding circuit is connected to the decoding output circuit, and the first decoding circuit is configured to decode a received command and output a corresponding decoded result; an input end of the second decoding circuit is connected to the output ends of the first delay sub-circuit and the second delay sub-circuit, an output end of the second decoding circuit is connected to the decoding output circuit, and the second decoding circuit is configured to decode a received command and output a corresponding decoded result; the decoding output circuit receives the output clock and is configured to output, in response to the output edge, the decoded result currently output by the first decoding circuit or the second decoding circuit as the decoding information of the memory command.

In some examples, an input end of the address output circuit is connected to the second even output and the second odd output, a clock end of the address output circuit receives the output clock, and the address output circuit is configured to output, in response to the output edge, a current output of the second even output end or the second odd output end as the address information of the memory command.

In some examples, the address output circuit includes: a first output circuit, a second output circuit, and an integration circuit; an input end of the first output circuit is connected to the second even output end, a clock end of the first output circuit receives the output clock, and the first output circuit is configured to output, in response to the output edge, the current output of the second even output end; an input end of the second output circuit is connected to the second odd output end, a clock end of the second output circuit receives the output clock, and the second output circuit is configured to output, in response to the output edge, the current output of the second odd output end; the integration circuit is coupled to the first output circuit and the second output circuit, and is configured to integrate the outputs of the first output circuit and the second output circuit and output an integrated output as the address information of the memory command.

In some examples, the command sampling circuit further includes: a clock generation circuit. The clock generation circuit receives the sampling clock, is coupled to the command decoding circuit and the address output circuit, and is configured to generate the output clock according to the sampling clock.

According to some embodiments, a second aspect of the present disclosure provides a memory. The memory includes the command sampling circuit, the command decoding circuit, and the address output circuit as described in the foregoing.

In the command sampling circuit and the memory provided by the embodiments of the present disclosure, the sampling circuit samples a memory command separately in response to a first sampling edge and a second sampling edge of a sampling clock, and outputs a first cycle command and a second cycle command; the sampling circuit has a first output end and a second output end, and the delay circuit delays a command output at the first output end of the sampling circuit and then outputs a delayed command; a command decoding circuit receives an output clock, decodes the commands output by the sampling circuit, and outputs, in response to an output edge of the output clock, a current decoded result as decoding information of the memory command; an address output circuit receives the output clock, and outputs, in response to the output edge, a command currently output at the second output end of the sampling circuit as address information of the memory command. According to this solution, the delay circuit delays the first cycle command output at the first output end of the sampling circuit, the command decoding circuit decodes a delayed first cycle command to obtain the decoding information, and in response to the output edge of the output clock, the decoding information and the address information of the memory command are output simultaneously by means of the command decoding circuit and the address output circuit, such that the transmission delay of the decoding information and the address information is shortened, and the efficiency of the command sampling is improved. In addition, an output logic for distinguishing the 1N mode from the 2N mode is reduced in the address output circuit, which simplifies the circuit and improves the performance of DRAM.

The construction of the present disclosure and other inventive purposes and beneficial effects thereof will be more apparent from the description of the preferred embodiments in conjunction with the drawings.

### BRIEF DESCRIPTION OF THE DRAWINGS

For a clearer illustration of the technical solutions in the embodiments of the present disclosure or in the prior art, the drawings required to be used in the description of the embodiments or the prior art are briefly introduced below. It is apparent that the drawings in the description below are for some embodiments of the present disclosure, and for those of ordinary skill in the art, other drawings may be obtained according to the drawings without creative efforts.
FIG. 1 is an exemplary diagram illustrating the architecture of an exemplary memory;
FIG. 2 is an exemplary diagram illustrating the structure of an exemplary memory cell;
FIG. 3 is a schematic diagram illustrating the structure of a command sampling circuit according to an example;
FIG. 4 is a schematic diagram illustrating the timing of command sampling output signals in a 1N mode and a 2N mode according to an example;
FIG. 5 is a schematic diagram illustrating the structure of an exemplary command sampling circuit;
FIG. 6 is a schematic diagram illustrating the timing of command sampling output signals in a 1N mode and a 2N mode according to an example;
FIG. 7 is a schematic diagram illustrating the structure of an exemplary command sampling circuit;
FIG. 8 is a timing diagram of an exemplary output clock PCSCLK;
FIG. 9 is a schematic diagram illustrating the structure of an exemplary command sampling circuit;
FIG. 10 is a schematic diagram illustrating the structure of the connection between the decoding circuit and the decoding output circuit;
FIG. 11 is a schematic diagram illustrating the structure of an address output circuit;
FIG. 12 is an exemplary diagram illustrating the structure of an exemplary memory.

Explicit embodiments of the present disclosure have been shown by way of the above drawings and will be described in more detail below. The drawings and written description are not intended to limit the scope of the disclosed concepts in any way, but rather to illustrate the disclosed concepts to those skilled in the art with reference to specific embodiments.

### DETAILED DESCRIPTION

Exemplary embodiments will be described in detail herein and examples thereof are illustrated in the drawings. The following description refers to the drawings in which the same numbers in different drawings represent the same or similar elements unless otherwise indicated. The implementations described in the exemplary embodiments below do not represent all implementations consistent with the present disclosure. Rather, they are merely examples of apparatus and methods consistent with certain aspects of the present disclosure.

The terms "comprising" and "having" in the present disclosure are used in the sense of open-ended inclusion and mean that additional elements/components/etc. may be present in addition to those listed; the logical symbol "/" is used to denote the logical meaning of "or"; the terms "first", "second", etc., are used only as labels or distinctions and are not intended to limit the ordering or number of their objects. Furthermore, the different elements and regions in the drawings are only schematically illustrated and thus are not limited to the dimensions or distances shown in the drawings. "Connection" in the present disclosure may be a direct connection or an indirect connection.

The technical solutions are described in detail below with specific embodiments. These several specific embodiments may be combined with each other below, and details of the same or similar concepts or processes may not be repeated in certain embodiments. The embodiments of the present disclosure are described below with reference to the drawings.

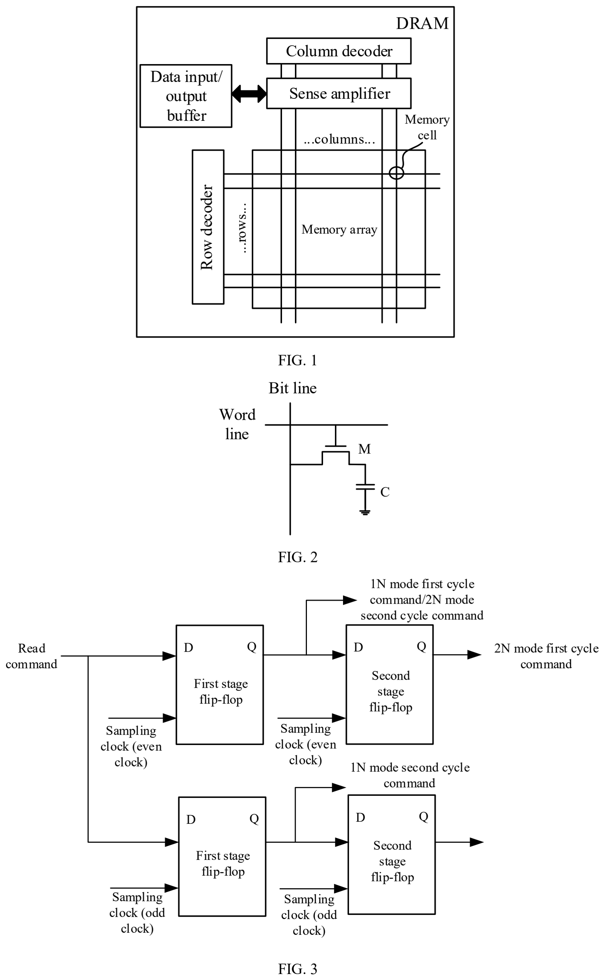

FIG. 1 is an exemplary diagram illustrating the architecture of an exemplary memory. As shown in FIG. 1, DRAM is taken as an example, which includes a data input/output buffer, a row decoder, a column decoder, a sense amplifier, and a memory array. The data input/output buffer belongs to the peripheral region circuit, and the sense amplifier, the row decoder, the column decoder, and the memory array belong to the array region circuit. The memory array mainly includes word lines, bit lines, and memory cells. The word lines in the memory array extend in a row direction, the bit lines in the memory array extend in a column direction, and the memory cells of the memory array are located at intersections of the word lines and the bit lines.

Each of the memory cells is configured to store one bit of data. As shown in FIG. 2, FIG. 2 is an exemplary diagram illustrating the structure of an exemplary memory cell. The memory cell mainly includes a transistor switch M and a capacitor C. The capacitor is configured to store data, and the transistor switch is configured to be turned off or turned on according to the selected state.

A certain memory cell can be activated by controlling the word lines and bit lines to gain access to the memory cell. In conjunction with a read scenario as an example: when data in a memory cell needs to be read, the word line of the row in which the memory cell is located can be selected by the row decoder, and correspondingly, the transistor M in the figure is turned on, and the state on the capacitor C at this time may be sensed by sensing and amplifying a bit line signal. For example, if the bit data stored in the memory cell is 1, 1 will be read from the bit line of the memory cell after the transistor M is turned on, and vice versa. In addition, in conjunction with a write scenario as an example: when bit data such as 1 needs to be written to a certain memory cell, the word line of the row in which the memory cell is located can be selected by the row decoder, and correspondingly, the transistor M in the figure is turned on, and the logic level of the bit line is set to 1, such that the capacitor C is charged, that is, 1 is written into the memory cell. Conversely, if 0 is to be written, the logic level of the bit line is set to 0, such that the capacitor C is discharged, that is, 0 is written to the memory cell.

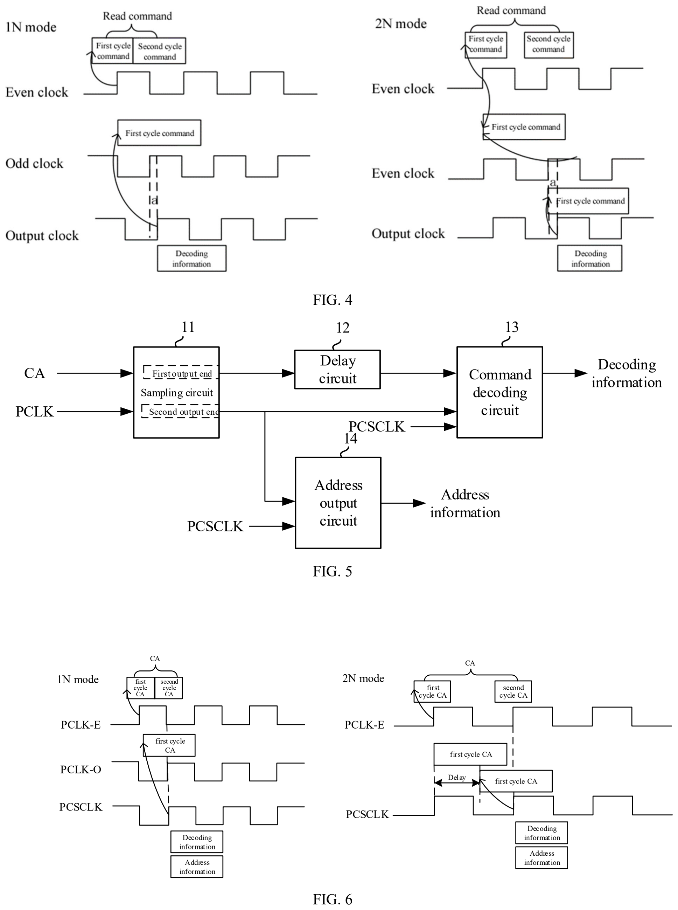

In conjunction with the aforementioned working principles of the memory, in practical applications, the memory receives a command signal. The command may be a read command, a write command, or other commands such as an activate command. Taking the read command as an example, FIG. 3 is a schematic diagram illustrating the structure of a command sampling circuit according to an example. The read command is divided into two cycles to sample command information and address information and needs to output the decoding information of the command information and the address information simultaneously. The exemplary circuit in FIG. 3 includes two paths and each path is provided with multiple stages of flip-flops, i.e., a first stage flip-flop and a second stage flip-flop. Taking sampling data first by an even clock as an example, in a 1N mode, a first stage flip-flop under an even clock path acquires, in response to a first rising edge of the even clock, a first cycle command and sends the first cycle command to a command decoding circuit to obtain decoding information; after 1T (external clock cycle), a first stage flip-flop under an odd clock path acquires, in response to a first rising edge of an odd clock, a second cycle command and sends the second cycle command to an address output circuit to obtain address information, and transmits the decoding information and the address information simultaneously when an output edge of an output clock arrives. In a 2N mode, sampling can be performed only by using an even clock or an odd clock. Taking sampling by using the even clock as an example, on a first rising edge of the even clock, a first stage flip-flop under an even clock path samples a first cycle command, and on a second rising edge of the even clock after 2T (external clock cycle), the first stage flip-flop under the even clock path samples a second cycle command and sends the second cycle command to an address output circuit to obtain address information, and at this time, a second stage flip-flop under the even clock path samples the first cycle command output before the first stage flip-flop updates the output, and transmits the first cycle command to a command decoding circuit to obtain decoding information. That is, to ensure simultaneous output of the decoding information and the address information, the first cycle command is not sent to the decoding circuit after the first rising edge of the even clock, but the first cycle command is transmitted to the command decoding circuit by using the second stage flip-flop only when the second rising edge of the even clock arrives, and then the decoding information and the address information are transmitted simultaneously when the output edge of the output clock in the 2N mode arrives. As an example, FIG. 4 is a schematic diagram illustrating the timing of command sampling output signals in a 1N mode and a 2N mode according to an example. The sampling process of the second cycle command is not shown in the timing diagram. Instead, the focus is primarily on the timing of the sampling and transmission process of the first cycle command (the arrows in the figure indicate sampling or sampling output). In the 2N mode, a first first cycle command with a length of 2T (external clock cycle) is a command output by the first stage flip-flop when a first rising edge arrives, and a second first cycle command with a length of 2T (external clock cycle) is a command output by the second stage flip-flop when a second rising edge arrives, which is transmitted to the command decoding circuit. It can be understood that, since the first cycle command is transmitted to the command decoding circuit after the second rising edge arrives, the output edge of the output clock in this example needs to be delayed by a certain time (such as a time delay a between two dashed lines in FIG. 4) compared with the second rising edge, thereby correctly sampling the decoding information output by the command decoding circuit. In this delay, the setup and hold time of stages of flip-flops and the time required for the command decoding circuit to perform the decoding process, etc. need to be taken into account.

This results in some problems. For example, in practical applications, to simplify the circuit and save space, the output clocks in the 1N mode and the 2N mode are usually generated by the same clock generation circuit, which causes the output clock in the 1N mode to also be applied with the delay a, thereby reducing the sampling efficiency. Moreover, in the case of high frequency, the time a of the above delay may be greater than a single external clock cycle 1T, which may cause the output edge of the output clock in the 1N mode to miss the data window of the decoding information, resulting in a failure of sampling in the 1N mode.

Some aspects of embodiments of the present disclosure relate to the above considerations. The solutions are exemplified and introduced below in conjunction with some embodiments.

### Embodiment 1

FIG. 5 is a schematic diagram illustrating the structure of an exemplary command sampling circuit. As shown in FIG. 5, the command sampling circuit includes: a sampling circuit 11 and a delay circuit 12. The sampling circuit 11 receives a memory command CA and a sampling clock PCLK, and is configured to sample the memory command CA separately in response to a first sampling edge and a second sampling edge of the sampling clock PCLK, and output a first cycle command first cycle CA and a second cycle command second cycle CA; the sampling circuit 11 has a first output end OUT1 and a second output end OUT2; an input end of the delay circuit 12 is connected to the first output end OUT1 of the sampling circuit 11, an output end of the delay circuit 12 is connected to the command decoding circuit 13, and the delay circuit 12 is configured to delay a command output at the first output end OUT1 of the sampling circuit 11 and then output a delayed command; a command decoding circuit 13 is coupled to the command sampling circuit, receives an output clock PCSCLK, and is configured to decode the commands output by the sampling circuit 11, and output, in response to an output edge of the output clock PCSCLK, a current decoded result as decoding information of the memory command CA; the second output end OUT2 of the sampling circuit 11 is connected to an address output circuit 14; the address output circuit 14 receives the output clock PCSCLK, and is configured to output, in response to the output edge, a command currently output at the second output end OUT2 of the sampling circuit 11 as address information of the memory command CA.

In practical applications, the circuits provided in this embodiment can be applied to various memories, as an example, including, but not limited to, a dynamic random access memory (DRAM). The sampling circuit 11 receives a memory command CA and a sampling clock PCLK, and samples the memory command CA separately in response to a first sampling edge and a second sampling edge of the sampling clock PCLK. The sampling circuit 11 has a first output end OUT1 and a second output end OUT2. PCLK is a frequency divided clock for an external clock CK and includes an odd clock PCLK-O and an even clock PCLK-E, both of which have a clock cycle twice that of CK and a phase difference of 180°. The memory command CA includes a command-related command and an address-related command in a first cycle and an address-related command in a second cycle.

Two modes are present when the memory command CA is sampled and output, i.e., 1N mode and 2N mode. FIG. 6 is a schematic diagram illustrating the timing of command sampling output signals in a 1N mode and a 2N mode according to an example. Taking sampling the command first by an even clock PCLK-E as an example, in the 1N mode, when a first sampling edge of the sampling clock PCLK (as exemplified by PCLK-E in FIG. 6) arrives, the memory command CA is sampled, and a first cycle command first cycle CA is output at the second output end; when a second sampling edge of the sampling clock PCLK (as exemplified by PCLK-O in FIG. 6) arrives, the memory command CA is sampled, and a second cycle command second cycle CA is output at the second output end. In the 2N mode, the memory command CA is sampled at a first sampling edge of the sampling clock PCLK (as exemplified by PCLK-E in FIG. 6), i.e., a first rising edge of the sampling clock PCLK-E, and a first cycle command first cycle CA is output at the first output end; the memory command CA is sampled at a second sampling edge of the sampling clock PCLK-E, i.e., a second rising edge after the first rising edge of PCLK-E, and a second cycle command second cycle CA is output at the second output end. It should be noted that, in the 1N mode, the phase difference between the first sampling edge and the second sampling edge is one external clock cycle; in the 2N mode, the phase difference between the first sampling edge and the second sampling edge is two external clock cycles.

For example, command address pin ends of the memory are configured to receive the command information CA indicating the specific command and address for the memory to operate. Taking the read command of DDR5 DRAM as an example, the command CA information received by a part of the pin ends is shown in Table 1.

**Table 1**

| CS_n | CA0 | CA1 | CA2 | CA3 | CA4 | CA5 | CA6 | CA7 | CA8 | CA9 | CA10 |
|---|---|---|---|---|---|---|---|---|---|---|---|
| L | H | L | H | H | H | BL* = L | BA0 | BA1 | BG0 | BG1 | BG2 |
| H | C2 | C3 | C4 | C5 | C6 | C7 | C8 | C9 | C10 | V | H |

In the above table, the first row represents specific pins receiving a command, the second row represents commands first cycle CA received by the corresponding pins in the first cycle, and the third row represents commands second cycle CA received by the corresponding pins in the second cycle. As can be seen from the above table, the first cycle command first cycle CA includes command information required for decoding specific command and address information for which the command is operated, and the second cycle command second cycle CA includes address information for which the command is operated.

Specifically, an input end of the delay circuit 12 is connected to the first output end OUT1 of the sampling circuit 11, an output end of the delay circuit 12 is connected to the command decoding circuit 13, and the delay circuit 12 delays a first cycle command first cycle CA output at the first output end of the sampling circuit 11 and outputs a delayed first cycle command first cycle CA to the command decoding circuit 13. The command decoding circuit 13 is coupled to the command sampling circuit, and receives a first cycle command first cycle CA output at the second output end OUT2 of the sampling circuit 11 or the delayed first cycle command first cycle CA output at the output end of the delay circuit 12. The command decoding circuit 13 decodes a received first cycle command first cycle CA to obtain decoding information corresponding to the first cycle command first cycle CA. The sampling clock PCLK is delayed to obtain an output clock PCSCLK. The command decoding circuit 13 receives the output clock PCSCLK and outputs, in response to an output edge of the output clock PCSCLK, a current decoded result as decoding information of a memory CA command when the output edge arrives. The second output end OUT2 of the sampling circuit 11 is connected to the address output circuit 14, which receives the same output clock PCSCLK, and outputs, in response to the output edge of the output clock PCSCLK, the second cycle command second cycle CA currently output at the second output end OUT2 of the sampling circuit 11 as address information of the memory command CA simultaneously with the decoding information of the command when the output edge arrives.

As an example in conjunction with the foregoing and FIG. 6, in the 1N mode, when the first sampling edge of the sampling clock PCLK arrives, a part of the first cycle command first cycle CA regarding the command in Table 1 is output at the second output end and transmitted to the command decoding circuit 13 for decoding; when the second sampling edge of the sampling clock PCLK arrives, the second cycle command second cycle CA in Table 1 is output at the second output end and transmitted to the address output circuit 14. Correspondingly, in the 2N mode, when the first sampling edge of the sampling clock PCLK arrives, the first cycle command first cycle CA in Table 1 is output at the first output end and transmitted to the command decoding circuit 13 for decoding; when the second sampling edge of the sampling clock PCLK arrives, the second cycle command second cycle CA in Table 1 is output at the second output end and transmitted to the address output circuit 14. At this time, the command decoding circuit 13 receives the first cycle command first cycle CA to decode. Since the output edge has not arrived yet at this time, the decoding information obtained in the decoding process is temporarily stored, and when the output edge of the output clock PCSCLK arrives, the currently obtained decoding information of the command is valid, and the currently obtained decoding information is output as the decoding information of the memory command CA. Likewise, the address output circuit 14 receives the second cycle command second cycle CA to perform corresponding processing, and when the output edge of the output clock PCSCLK arrives, the currently obtained address information is valid, and the currently obtained address information is output as the address information of the memory command CA.

Compared with the example technology, in this solution, there is no need to set multiple stages of flip-flops to control the output of the first cycle command first cycle CA, instead, sampling delay is performed on the first cycle command first cycle CA in conjunction with the delay circuit 12, and the setting time interval and the sampling margin for the output edge are larger in the range than those in the example technology, such that the decoding information of the command can be prepared earlier by using the circuit of this solution, and the sampling margin of the output clock is larger; furthermore, the output edge of the output clock can arrive earlier, such that the decoding information and the address information are output in advance, thereby improving the efficiency and quality of command sampling.

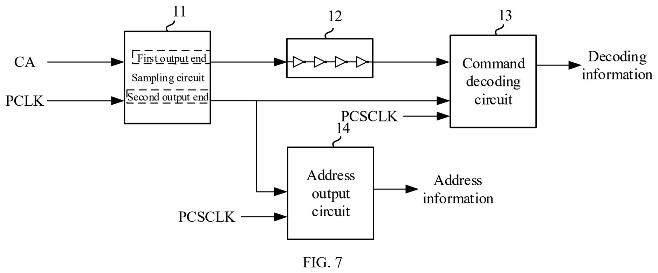

On the basis of the foregoing examples, in one example, the delay circuit 12 includes an even number of inverters. FIG. 7 is a schematic structure diagram of an exemplary command sampling circuit. It should be noted that, this is only an example. The delay circuit 12 may include an even number of cascaded inverters, may be an even number of cascaded inverters, may be a delay formed by a CMOS capacitor similar to an inverter, etc., as long as the delay function is satisfied. According to the actual delay requirement, the number of inverters is not specifically limited, and the number of inverters can be set according to the required delay time, to be, e.g., 2, 4, 6, 8, etc., as long as an even number of inverters is satisfied. As shown in FIG. 7, the delay circuit 12 includes 4 cascaded inverters. In the above example, by providing an even number of inverters in the delay circuit 12, the level signals before and after the delay are kept consistent and the first cycle command first cycle CA output at the first output end of the sampling circuit 11 can be delayed, such that the decoding information and the address information of the memory command CA are output simultaneously. The delay amount of the delay circuit 12 may be Dly as shown in FIG. 6.

In one example, the output edge of the output clock PCSCLK is located at the second sampling edge (as exemplified in FIG. 6), or is located after the second sampling edge and has a preset delay amount delay relative to the second sampling edge, the delay amount delay satisfying a timing requirement required for sampling at the output edge.

Specifically, when the decoding information and the address information are output, the command decoding circuit 13 and the address output circuit 14 need to output in response to the output edge of the output clock PCSCLK, and when the output edge of the output clock PCSCLK arrives, the decoding information and the address information are output simultaneously. The output clock PCSCLK is generated according to the sampling clock PCLK, and the output edge of the output clock PCSCLK may be located at the second sampling edge of the sampling clock PCLK, or may be located after the second sampling edge of the sampling clock PCLK by a preset delay amount delay. The delay amount delay only needs to satisfy the timing requirement for sampling under the output edge, that is, the decoding information and the address information can be output simultaneously at the output edge obtained after the second sampling edge is delayed.

In conjunction with the content of the foregoing example, the output clock PCSCLK includes a first output clock corresponding to the 1N mode and a second output clock corresponding to the 2N mode. The output edge of the first output clock corresponds to the second sampling edge in the 1N mode or the position of the second sampling edge in the 1N mode delayed by the delay amount; the output edge of the second output clock corresponds to the second sampling edge in the 2N mode or the position of the second sampling edge in the 2N mode delayed by the delay amount delay.

According to the solution of this example, the output clock PCSCLK is generated according to the sampling clock PCLK, the output edge of the output clock PCSCLK may be the second sampling edge, or may be after the second sampling edge and have a preset delay amount relative to the second sampling edge, and when the output edge of the output clock PCSCLK arrives, the decoding information and the address information of the command are output simultaneously, such that the transmission delay is shortened by the decoding information and the address information, and the performance of the DRAM is improved.

On the basis of the foregoing example, the sampling circuit 11 and the command decoding circuit 13 both include a flip-flop; the delay amount delay includes a setup time of the flip-flop in the command decoding circuit 13 and a hold time of the flip-flop in the sampling circuit 11.

Specifically, the sampling circuit 11 and the command decoding circuit 13 both include a flip-flop, and when the output edge of the output clock PCSCLK is located after the second sampling edge and has a preset delay amount delay relative to the second sampling edge, the delay amount delay includes a setup time of the flip-flop in the decoding circuit 13 and a hold time of the flip-flop in the sampling circuit 11. The setup time of the flip-flop refers to a time during which the data input at the data end must remain unchanged before the sampling edge of the sampling clock of the flip-flop arrives. The hold time of the flip-flop refers to a time during which data input at the data end must remain unchanged after the sampling edge of the sampling clock of the flip-flop arrives. Specifically, in the embodiments of the present disclosure, the hold time of the flip-flop in the sampling circuit 11 refers to a time during which the first cycle command first cycle CA must remain unchanged after the sampling edge of the sampling clock PCLK arrives. The setup time of the flip-flop in the command decoding circuit 13 refers to a time during which the first cycle command first cycle CA must remain unchanged before the output edge of the output clock PCSCLK arrives.

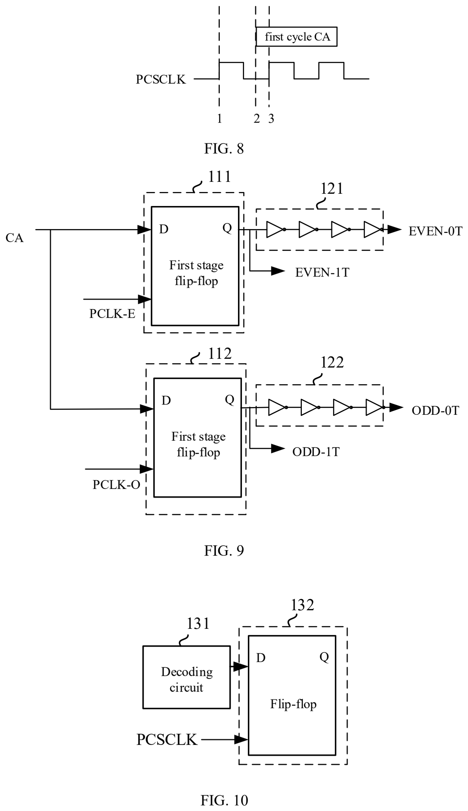

On the basis of this, to keep the decoding information corresponding to the first cycle command first cycle CA capable of being output when the output edge arrives, in one example, the delay amount delay is not greater than a difference between a time that elapsed between the first sampling edge and the second sampling edge and the setup time of the flip-flop in the command decoding circuit 13. FIG. 8 is a timing diagram of an exemplary output clock PCSCLK. As shown in FIG. 8, in the 2N mode, the time that elapsed between the dashed line 1 and the dashed line 3 is the time that elapsed between the first sampling edge and the second sampling edge, i.e., two external clock cycles, and the time that elapsed between the dashed line 2 and the dashed line 3 is the setup time of the flip-flop in the command decoding circuit 13. Therefore, it can be derived that the time difference between the dashed line 1 and the dashed line 2 is the time that elapsed between the first sampling edge and the second sampling edge minus the setup time of the flip-flop in the command decoding circuit 13, and the maximum delay amount delay of the first cycle command first cycle CA cannot exceed the difference between the time that elapsed between the first sampling edge and the second sampling edge and the setup time of the flip-flop in the command decoding circuit 13, i.e., the difference between two external clock cycles and the setup time of the flip-flop in the command decoding circuit 13.

In the above example, the delay amount delay of the output clock PCSCLK is set so as to ensure that the decoding information and the address information of the memory command CA are output simultaneously when the output edge of the output clock PCSCLK arrives. Meanwhile, the time for outputting the decoding information and the address information can be regulated according to the required sampling margin and output time requirements.

In one example, FIG. 9 is a schematic diagram illustrating the structure of an exemplary command sampling circuit. As shown in FIG. 9, the sampling clock PCLK includes an odd clock PCLK-O and an even clock PCLK-E; the sampling circuit 11 includes: a first sampling sub-circuit 111 and a second sampling sub-circuit 112, the first sampling sub-circuit 111 having a first even output end and a second even output end EVEN-1T, and the second sampling sub-circuit 112 having a first odd output end and a second odd output end ODD-1T; an input end of the first sampling sub-circuit 111 is connected to an input end of the second sampling sub-circuit 112 for receiving the memory command CA; a clock end of the first sampling sub-circuit 111 receives the even clock PCLK-E, and a clock end of the second sampling sub-circuit 112 receives the odd clock PCLK-O; the delay circuit 12 includes: a first delay sub-circuit 121 and a second delay sub-circuit 122, the first even output end being connected to an input end of the first delay sub-circuit 121, and the first odd output end being connected to an input end of the second delay sub-circuit 122; an output end EVEN-0T of the first delay sub-circuit 121, an output end ODD-0T of the second delay sub-circuit 122, and the second even output end EVEN-1T and the second odd output end ODD-1T are all connected to the command decoding circuit 13; the second even output end EVEN-1T and the second odd output end ODD-1T are connected to the address output circuit 14.

Specifically, the sampling circuit 11 includes a first sampling sub-circuit 111 and a second sampling sub-circuit 112, the first sampling sub-circuit 111 and the second sampling sub-circuit 112 receiving the memory command CA. A first even output end of the first sampling sub-circuit 111 is connected to the first delay sub-circuit 121, and a first odd output end of the second sampling sub-circuit 112 is connected to the second delay sub-circuit 122.

In the 1N mode, the first sampling sub-circuit 111 and the second sampling sub-circuit 112 receive the memory command CA, a clock end of the first sampling sub-circuit 111 receives the even clock PCLK-E, and if a first cycle command arrives at the first rising edge of the even clock PCLK-E, it will be acquired by the first sampling sub-circuit, and in response to the first sampling edge, i.e., the first rising edge of the even clock PCLK-E, the first cycle command first cycle CA is output at the second even output end EVEN-1T of the first sampling sub-circuit 111 to the command decoding circuit 13; a clock end of the second sampling sub-circuit 112 receives the odd clock PCLK-O, and in response to the second sampling edge, i.e., the rising edge of the odd clock PCLK-O immediately following the first rising edge of the even clock PCLK-E, the second odd output end ODD-1T of the second sampling sub-circuit 112 samples the second cycle command second cycle CA and outputs the second cycle command second cycle CA to the address output circuit 14. Similarly, if a first cycle command arrives at the first rising edge of the odd clock PCLK-O, it will be acquired by the second sampling sub-circuit, and in response to the first sampling edge, i.e., the first rising edge of the odd clock PCLK-O, the first cycle command first cycle CA is output at the second odd output end ODD-1T of the second sampling sub-circuit 112 to the command decoding circuit 13; a clock end of the first sampling sub-circuit 111 receives the even clock PCLK-E, and in response to the second sampling edge, i.e., the rising edge immediately following the even clock PCLK-E after the first rising edge of the odd clock PCLK-O, the second even output end EVEN-1T of the first sampling sub-circuit 111 samples the second cycle command second cycle CA and outputs the second cycle command second cycle CA to the address output circuit 14.

In the 2N mode, the first sampling sub-circuit 111 and the second sampling sub-circuit 112 receive the memory command CA, and if a first cycle command arrives at the first rising edge of the even clock PCLK-E, it will be acquired by the first sampling sub-circuit 111, a clock end of the first sampling sub-circuit 111 receives the even clock PCLK-E, and in response to the first sampling edge, i.e., the first rising edge of the even clock PCLK-E, outputs the first cycle command first cycle CA at the first even output end of the first sampling sub-circuit 111 to the first delay sub-circuit 121, and after delaying, the first cycle command first cycle CA is output at the output end EVEN-0T of the first delay sub-circuit 121 to the command decoding circuit 13; in response to the second sampling edge of the even clock PCLK-E, i.e., the second rising edge after the first rising edge of the even clock PCLK-E, the second cycle command second cycle CA is output at the second even output end EVEN-1T of the first sampling sub-circuit 111 to the address output circuit 14. If a first cycle command arrives at the first rising edge of the odd clock PCLK-O, it will be acquired by the second sampling sub-circuit 112, a clock end of the second sampling sub-circuit 112 receives the odd clock PCLK-O, and in response to the first sampling edge, i.e., the first rising edge of the odd clock PCLK-O, outputs the first cycle command first cycle CA at the first odd output end of the second sampling sub-circuit 112 to the second delay sub-circuit 122, and after delaying, the first cycle command first cycle CA is output at the output end ODD-0T of the second delay sub-circuit 122 to the command decoding circuit 13; in response to the second sampling edge of the odd clock PCLK-O, i.e., the second rising edge after the first rising edge of the odd clock PCLK-O, the second cycle command second cycle CA is output at the second ODD output end ODD-1T of the second sampling sub-circuit 112 to the address output circuit 14.

According to the solution of this example, the sampling clock PCLK includes an odd clock PCLK-O and an even clock PCLK-E, the sampling circuit 11 includes a first sampling sub-circuit 111 and a second sampling sub-circuit 112, the delay circuit 12 includes a first delay sub-circuit 121 and a second delay sub-circuit 122, and for the 1N mode and the 2N mode, the first cycle command first cycle CA and the second cycle command second cycle CA are output at different output ends to the command decoding circuit 13 and the address output circuit 14, respectively, such that the timing sequence of command transmission is ensured.

In one example, the command decoding circuit 13 includes a decoding circuit 131 and a decoding output circuit 132; an input end of the decoding circuit 131 is connected to the output end EVEN-0T of the first delay sub-circuit 121, the output end ODD-0T of the second delay sub-circuit 122, and the second even output end EVEN-1T and the second odd output end ODD-1T, an output end of the decoding circuit 131 is connected to the decoding output circuit 132, and the decoding circuit 131 is configured to perform decoding processing; the decoding output circuit 132 receives an output clock PCSCLK and is configured to output, in response to the output edge, a decoded result currently output by the decoding circuit 131 as the decoding information of the memory command CA.

FIG. 10 is a schematic diagram illustrating the structure of the connection between the decoding circuit 131 and the decoding output circuit 132. The decoding circuit 131 is configured to perform decoding processing on a received command. In practical applications, decoding processing can be implemented by some logic gates such as an NAND gate and an NOR gate. The input end of the decoding circuit 131 is connected to the output end EVEN-0T of the first delay sub-circuit 121, the output end ODD-0T of the second delay sub-circuit 122, and the second even output end EVEN-1T and the second odd output end ODD-1T, receives a part of the first cycle command first cycle CA regarding the command, and performs decoding processing thereon, for example, decodes a read command according to Cs_n and CA0-CA4 in the first cycle in Table 1. The output end of the decoding circuit 131 is connected to the decoding output circuit 132. The decoding output circuit 132 includes a flip-flop. The first cycle command s first cycle CA output at the output end EVEN-0T of the first delay sub-circuit 121, the output end ODD-0T of the output end of the second delay sub-circuit 122, and the second even output end EVEN-1T and the second odd output end ODD-1T are decoded by the decoding circuit 131 to obtain decoding information, and the decoding information is transmitted to the flip-flop in the decoding output circuit 132. The flip-flop in the decoding output circuit 132 receives the output clock PCSCLK, and outputs, in response to the output edge, a decoded result currently output by the decoding circuit 131 as the decoding information of the command of the memory command CA.

In the above example, the first cycle command first cycle CA output at any one of the output end EVEN-0T of the first delay sub-circuit 121, the output end ODD-0T of the second delay sub-circuit 122, the second even output end EVEN-1T, and the second odd output end ODD-1T is decoded by the decoding circuit 131, and in response to the output edge of the output clock PCSCLK, a decoded result currently output by the decoding circuit 131 is output as the decoding information of the memory command CA, thereby ensuring the accuracy of the output of the decoding information.

In conjunction with the foregoing examples, in the 1N mode and the 2N mode, the decoding circuit 131 includes: a first decoding circuit corresponding to the 1N mode and a second decoding circuit corresponding to the 2N mode; an input end of the first decoding circuit is connected to the second even output end EVEN-1T and the second odd output end ODD-1T, an output end of the first decoding circuit is connected to the decoding output circuit 132, and the first decoding circuit is configured to decode a received command and output a corresponding decoded result; an input end of the second decoding circuit is connected to the output end EVEN-0T of the first delay sub-circuit 121 and the output end ODD-0T of the second delay sub-circuit 122, an output end of the second decoding circuit is connected to the decoding output circuit 132, and the second decoding circuit is configured to decode a received command and output a corresponding decoded result; the decoding output circuit 132 receives the output clock PCSCLK, and in response to an output edge, outputs the decoded result currently output by the first decoding circuit or the second decoding circuit as decoding information of the memory command CA.

In practical applications, since the correspondence between the sampling clock and the output clock is different in the 1N mode and the 2N mode, a first decoding circuit corresponding to the 1N mode and a second decoding circuit corresponding to the 2N mode are provided. Furthermore, considering that the sampling clock of the first cycle command first cycle CA may be an even clock or an odd clock, and to ensure the reliability of the sampling, a first decoding circuit corresponding to the even clock and a first decoding circuit corresponding to the odd clock are further provided in the first decoding circuit in the 1N mode; a second decoding circuit corresponding to the even clock and a second decoding circuit corresponding to the odd clock are further provided in the second decoding circuit in the 2N mode. Likewise, considering the reliability of the sampling, the output clock PCSCLK includes an even output clock PCSCLK-E and an odd output clock PCSCLK-O. The decoding output circuit 132 includes two flip-flops. The first flip-flop receives the even output clock PCSCLK-E and the second flip-flop receives the odd output clock PCSCLK-O.

Specifically, as an example, in the 1N mode, an input end of the first decoding circuit corresponding to the even clock is connected to the second even output end EVEN-1T, and an input end of the first decoding circuit corresponding to the odd clock is connected to the second odd output end ODD-1T. An output end of the first decoding circuit corresponding to the even clock is connected to the second flip-flop in the decoding output circuit 132 and is responsive to the odd output clock PCSCLK-O. An output end of the first decoding circuit corresponding to the odd clock is connected to the first flip-flop in the decoding output circuit 132 and is responsive to the even output clock PCSCLK-E. The first decoding circuit corresponding to the even clock receives the first cycle command first cycle CA output at the second even output end EVEN-1T, decoding is performed by the first decoding circuit corresponding to the even clock to obtain decoding information, and when an output edge of the odd output clock PCSCLK-O arrives, the current decoded result is output as the decoding information of the memory command CA. The input end of the first decoding circuit corresponding to the odd clock receives the first cycle command first cycle CA output at the second odd output end ODD-1T, decoding is performed by the first decoding circuit corresponding to the odd clock to obtain decoding information, and when an output edge of the even output clock PCSCLK-E arrives, the current decoded result is output as the decoding information of the memory command CA.

Correspondingly, in the 2N mode, an input end of the second decoding circuit corresponding to the even clock is connected to the output end EVEN-0T of the first delay sub-circuit 121, and an input end of the second decoding circuit corresponding to the odd clock is connected to the output end ODD-0T of the second delay sub-circuit 122. An output end of the second decoding circuit corresponding to the even clock is connected to the first flip-flop in the decoding output circuit 132 and is responsive to the even output clock PCSCLK-E. An output end of the second decoding circuit corresponding to the odd clock is connected to the second flip-flop in the decoding output circuit 132 and is responsive to the odd output clock PCSCLK-O. The input end of the second decoding circuit corresponding to the even clock receives the first cycle command first cycle CA output at the output end EVEN-0T of the first delay sub-circuit 121, decoding is performed by the second decoding circuit corresponding to the even clock to obtain decoding information, and when an output edge of the even output clock PCSCLK-E arrives, the current decoded result is output as the decoding information of the memory command CA. The input end of the second decoding circuit corresponding to the odd clock receives the first cycle command first cycle CA output at the output end ODD-0T of the second delay sub-circuit 122, decoding is performed by the second decoding circuit corresponding to the odd clock to obtain decoding information, and when an output edge of the odd output clock PCSCLK-O arrives, the current decoded result is output as the decoding information of the memory command CA.

In the above example, the decoding circuit 131 includes a first decoding circuit in the 1N mode and a second decoding circuit in the 2N mode, which enriches the decoding modes of the memory command CA in different scenarios so as to output the decoding information.

In one example, an input end of the address output circuit 14 is connected to the second even output end EVEN-1T and the second odd output end ODD-1T, a clock end of the address output circuit 14 receives the output clock PCSCLK, and the address output circuit 14 is configured to output, in response to the output edge, the current output of the second even output end EVEN-1T or the second odd output end ODD-1T as the address information of the memory command CA.

Specifically, the second even output end EVEN-1T and the second odd output end ODD-1T of the sampling circuit 11 are connected to the address output circuit 14, and in the 1N mode and the 2N mode, the second cycle command second cycle CA of the memory command CA is acquired at the second sampling edge of the even clock PCLK-E of the sampling clock and output at the second even output end EVEN-1T, and the second cycle command second cycle CA of the memory command CA is acquired at the second sampling edge of the odd clock PCLK-O of the sampling clock and output at the second odd output end ODD-1T. The input end of the address output circuit 14 is connected to the second even output end EVEN-1T and the second odd output end ODD-1T, and the address output circuit 14 receives the second cycle command second cycle CA output at the second even output end EVEN-1T and the second odd output end ODD-1T, and outputs, in response to the output edge of the output clock PCSCLK, the current output of the second even output end EVEN-1T or the second odd output end ODD-1T as the address information of the memory command CA. According to the solution of this example, for the second cycle command, since the address information in both the 1N mode and the 2N mode is output through the second even output end EVEN-1T or the second odd output end ODD-1T, the second cycle command second cycle CA directly arrives at the address output circuit 14 to be output, such that a logic for distinguishing 1N from 2N of the second cycle address output circuit can be removed. This can save the circuit area and enable the address information to arrive earlier, thereby improving the margin of the setup time.

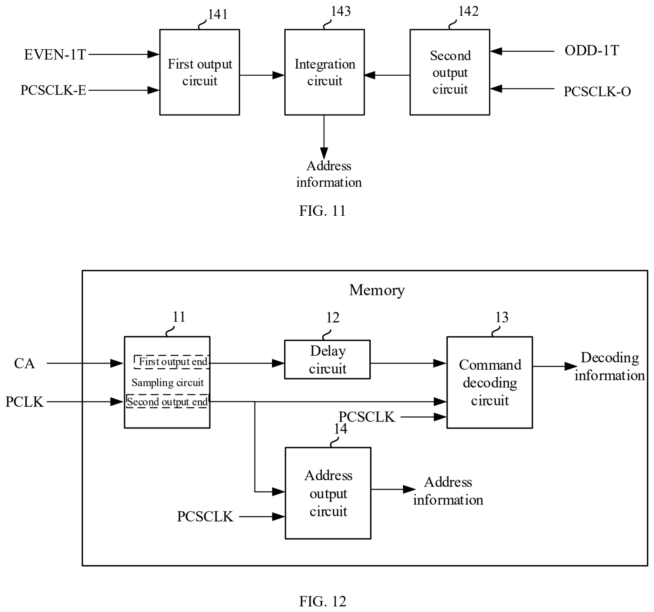

FIG. 11 is a schematic diagram illustrating the structure of the address output circuit 14. As shown in FIG. 11, on the basis of the foregoing example, the address output circuit 14 includes: a first output circuit 141, a second output circuit 142, and an integration circuit 143; an input end of the first output circuit 141 is connected to the second even output end EVEN-1T, a clock end of the first output circuit 141 receives the output clock PCSCLK, and the first output circuit outputs, in response to the output edge, a current output of the second even output end EVEN-1T; an input end of the second output circuit 142 is connected to the second odd output end ODD-1T, a clock end of the second output circuit 142 receives the output clock PCSCLK, and the second output circuit outputs, in response to the output edge, a current output of the second odd output end ODD-1T; the integration circuit 143 is coupled to the first output circuit 141 and the second output circuit 142 and is configured to integrate the outputs of the first output circuit 141 and the second output circuit 142 and output an integrated output as the address information of the memory command CA.

Still considering that the clock for sampling the first cycle data may be an even clock or an odd clock in practical applications, and to ensure reliable sampling, as an example, the address output circuit 14 includes a first output circuit 141, a second output circuit 142, and an integration circuit 143. In both the 1N mode and the 2N mode, the input end of the first output circuit 141 receives the second cycle command second cycle CA output at the second even output end EVEN-1T, and the first output circuit outputs, in response to the output edge of the even output clock PCSCLK-E, a current output of the second even output end EVEN-1T; the input end of the second output circuit 142 receives the second cycle command second cycle CA output at the second odd output end ODD-1T, and the second output circuit outputs, in response to the output edge of the odd output clock PCSCLK-O, a current output of the second odd output end ODD-1T. Likewise, the integration circuit 143 integrates, in response to the output edge of the odd output clock PCSCLK-O or the output edge of the even output clock PCSCLK-E, the current outputs of the second even output end EVEN-1T and the current output of the second odd output end ODD-1T and outputs an integrated result as the address information of the memory command CA. In the above example, for the second cycle command second cycle CA, since the address information in both the 1N mode and the 2N mode is output through the second even output end EVEN-1T or the second odd output end ODD-1T, the second cycle command second cycle CA directly arrives at the address output circuit 14 to be output, such that a logic for distinguishing 1N from 2N of the second cycle address output circuit can be removed. This can save the circuit area and enable the address information to arrive earlier, thereby improving the margin of the setup time.

Illustratively, the first output circuit 141 and the second output circuit 142 may be flip-flops or latches. For example, the first output circuit 141 may be a flip-flop or latch that outputs the sampling address information at the even output clock PCSCLK-E, and the second output circuit 142 may be a flip-flop or latch that outputs the sampling address information at the odd output clock PCSCLK-O. The integration circuit may be a circuit composed of flip-flops or latches, or may be two gated inverters, and the control ends of the toggle clock or the gated inverters of the integration circuit receive the output clock signals PCSCLK-E and PCSCLK-O, respectively, such that the address information output at the odd output clock and the address information output at the even output clock are integrated into one path.

On the basis of any one of the foregoing examples, the command sampling circuit further includes: a clock generation circuit. The clock generation circuit receives the sampling clock PCLK, is coupled to the command decoding circuit 13 and the address output circuit 14, and is configured to generate the output clock PCSCLK according to the sampling clock PCLK.

Specifically, the command sampling circuit further includes a clock generation circuit. The clock generation circuit receives the sampling clock PCLK and generates the output clock PCSCLK according to the sampling clock PCLK. According to the foregoing embodiment, the clock generation circuit may directly obtain the output clock PCSCLK without any processing on the sampling clock PCLK, that is, the output clock PCSCLK and the sampling clock PCLK have the same source and frequency and may be regarded as one clock; the clock generation circuit may also directly obtain the output clock PCSCLK by performing delay processing on the sampling clock PCLK, and the design consideration of the specific delay amount delay is referred to in the foregoing and will not be repeated here. In the above example, the output clock PCSCLK is generated according to the sampling clock PCLK, thereby ensuring the output timing of the decoding information and address information of the memory command CA.

In the command sampling circuit provided by the embodiments of the present disclosure, the sampling circuit samples a memory command separately in response to a first sampling edge and a second sampling edge of a sampling clock, and outputs a first cycle command and a second cycle command; the sampling circuit has a first output end and a second output end, and the delay circuit delays a command output at the first output end of the sampling circuit and then outputs a delayed command; a command decoding circuit receives an output clock, decodes the commands output by the sampling circuit, and outputs, in response to an output edge of the output clock, a current decoded result as decoding information of the memory command; an address output circuit receives the output clock, and outputs, in response to the output edge, a command currently output at the second output end of the sampling circuit as address information of the memory command. According to this solution, the delay circuit delays the first cycle command output at the first output end of the sampling circuit, the command decoding circuit decodes a delayed first cycle command to obtain the decoding information, and in response to the output edge of the output clock, the decoding information and the address information of the memory command are output simultaneously by means of the command decoding circuit and the address output circuit, such that the transmission delay of the decoding information and the address information is shortened, and the efficiency of the command sampling is improved. In addition, an output logic for distinguishing the 1N mode from the 2N mode is reduced in the address output circuit, which simplifies the circuit and improves the performance of DRAM.

### Embodiment 2

FIG. 12 is an exemplary diagram illustrating the structure of an exemplary memory. As shown in FIG. 12, the memory includes: the command sampling circuit, the command decoding circuit 13, and the address output circuit 14 according to any one of the foregoing examples.

Specifically, in conjunction with the foregoing solutions, the sampling circuit 11 receives a memory command CA and a sampling clock PCLK, and samples the memory command CA separately in response to a first sampling edge and a second sampling edge of the sampling clock PCLK. The sampling circuit 11 has a first output end and a second output end.

Two modes are present when the memory command CA is acquired and output, i.e., 1N mode and 2N mode. In the 1N mode, when a first sampling edge of the sampling clock PCLK arrives, the memory command CA is sampled, and a first cycle command first cycle CA is output at the second output end; when a second sampling edge of the sampling clock PCLK arrives, the memory command CA is sampled, and a second cycle command second cycle CA is output at the second output end. In the 2N mode, the memory command CA is sampled at a first sampling edge of the sampling clock PCLK, i.e., a first rising edge of the sampling clock PCLK-E, and a first cycle command first cycle CA is output at the first output end; the memory command CA is sampled at a second sampling edge of the sampling clock PCLK-E, i.e., a second rising edge after the first rising edge of PCLK-E, and a second cycle command second cycle CA is output at the second output end. It should be noted that, in the 1N mode, the phase difference between the first sampling edge and the second sampling edge is one external clock cycle; in the 2N mode, the phase difference between the first sampling edge and the second sampling edge is two external clock cycles.

More specifically, an input end of the delay circuit 12 is connected to the first output end of the sampling circuit 11, an output end of the delay circuit 12 is connected to the command decoding circuit 13, and the delay circuit 12 delays the first cycle command first cycle CA output at the first output end of the sampling circuit 11 and outputs a delayed first cycle command first cycle CA to the command decoding circuit 13. The command decoding circuit 13 is coupled to the command sampling circuit, and receives the first cycle command first cycle CA output at the second output end of the sampling circuit 11 or the delayed first cycle command first cycle CA output at the output end of the delay circuit 12. The command decoding circuit 13 decodes a received first cycle command first cycle CA to obtain decoding information corresponding to the first cycle command first cycle CA. The sampling clock PCLK is delayed to obtain an output clock PCSCLK. The command decoding circuit 13 receives the output clock PCSCLK and outputs, in response to an output edge of the output clock PCSCLK, a current decoded result as decoding information of a memory command CA command when the output edge arrives. The second output end of the sampling circuit 11 is connected to the address output circuit 14, which receives the same output clock PCSCLK, and outputs, in response to the output edge of the output clock PCSCLK, the second cycle command second cycle CA currently output at the second output end of the sampling circuit 11 as address information of the memory command CA simultaneously with the decoding information of the command when the output edge arrives.

In the 1N mode, when the first sampling edge of the sampling clock PCLK arrives, a part of the first cycle command first cycle CA regarding the command is output at the second output end and transmitted to the command decoding circuit 13 for decoding; when the second sampling edge of the sampling clock PCLK arrives, the second cycle command second cycle CA is output at the second output end and transmitted to the address output circuit 14. Correspondingly, in the 2N mode, when the first sampling edge of the sampling clock PCLK arrives, the first cycle command first cycle CA is output at the first output end and transmitted to the command decoding circuit 13 for decoding; when the second sampling edge of the sampling clock PCLK arrives, the second cycle command second cycle CA is output at the second output end and transmitted to the address output circuit 14. At this time, the command decoding circuit 13 receives the first cycle command first cycle CA to decode. Since the output edge has not arrived yet at this time, the decoding information obtained in the decoding process is temporarily stored, and when the output edge of the output clock PCSCLK arrives, the currently obtained decoding information of the command is valid, and the currently obtained decoding information is output as the decoding information of the memory command CA. Likewise, the address output circuit 14 receives the second cycle command second cycle CA to perform corresponding processing, and when the output edge of the output clock PCSCLK arrives, the currently obtained address information is valid, and the currently obtained address information is output as the address information of the memory command CA.

In the memory provided by the embodiments of the present disclosure, the sampling circuit samples a memory command separately in response to a first sampling edge and a second sampling edge of a sampling clock, and outputs a first cycle command and a second cycle command; the sampling circuit has a first output end and a second output end, and the delay circuit delays a command output at the first output end of the sampling circuit and then outputs a delayed command; a command decoding circuit receives an output clock, decodes the commands output by the sampling circuit, and outputs, in response to an output edge of the output clock, a current decoded result as decoding information of the memory command; an address output circuit receives the output clock, and outputs, in response to the output edge, a command currently output at the second output end of the sampling circuit as address information of the memory command. According to this solution, the delay circuit delays the first cycle command output at the first output end of the sampling circuit, the command decoding circuit decodes a delayed first cycle command to obtain the decoding information, and in response to the output edge of the output clock, the decoding information and the address information of the memory command are output simultaneously by means of the command decoding circuit and the address output circuit, such that the transmission delay of the decoding information and the address information is shortened, and the efficiency of the command sampling is improved. In addition, an output logic for distinguishing the 1N mode from the 2N mode is reduced in the address output circuit, which simplifies the circuit and improves the performance of DRAM.

Other embodiments of the present disclosure will be apparent to those skilled in the art from consideration of the description and practice of the invention disclosed herein. The present disclosure is intended to encompass any variations, uses, or adaptive changes of the present disclosure that follow the general principles of the present disclosure and include common knowledge or customary technical means in the art not disclosed herein. The description and embodiments are considered as exemplary only.

It should be understood that the present disclosure is not limited to the precise structures that have been described above and shown in the drawings, and that various modifications and changes may be made without departing from the scope of the present disclosure.

## Claims

1. A command sampling circuit, comprising: a sampling circuit (11) and a delay circuit (12), wherein
the sampling circuit (11) receives a memory command (CA) and a sampling clock (PCLK), and is configured to sample the memory command separately in response to a first sampling edge and a second sampling edge of the sampling clock, and output a first cycle command (first cycle CA) and a second cycle command (second cycle CA); the sampling circuit (11) has a first output end (OUT1) and a second output end (OUT2);
an input end of the delay circuit is connected to the first output end of the sampling circuit, an output end of the delay circuit is connected to a command decoding circuit (13), and the delay circuit is configured to delay a command output at the first output end (OUT1) of the sampling circuit and then output a delayed command; the command decoding circuit is coupled to the command sampling circuit, receives an output clock (PCSCLK), and is configured to decode the commands output by the sampling circuit, and output, in response to an output edge of the output clock, a current decoded result as decoding information of the memory command;
the second output end (OUT2) of the sampling circuit (11) is connected to an address output circuit (14); the address output circuit (14) receives the output clock and is configured to output, in response to the output edge, a command currently output at the second output end of the sampling circuit as address information of the memory command.

2. The command sampling circuit according to claim 1, wherein the delay circuit (12) comprises an even number of inverters.

3. The command sampling circuit according to claim 1 or 2, wherein the output edge of the output clock (PCSCLK) is located at the second sampling edge, or is located after the second sampling edge and has a preset delay amount relative to the second sampling edge, the delay amount satisfying a timing requirement required for sampling at the output edge.

4. The command sampling circuit according to claim 3, wherein the sampling circuit (11) and the command decoding circuit (13) both comprise a flip-flop; the delay amount comprises a setup time of a flip-flop in the command decoding circuit and a hold time of a flip-flop in the sampling circuit.

5. The command sampling circuit according to claim 3 or 4, wherein the delay amount is not greater than a difference between a time that elapsed between the first sampling edge and the second sampling edge and the setup time of the flip-flop in the command decoding circuit.

6. The command sampling circuit according to any one of claims 1-5, wherein the sampling clock (PCLK) comprises an odd clock (PCLK-O) and an even clock (PCLK-E);
the sampling circuit (11) comprises a first sampling sub-circuit (111) and a second sampling sub-circuit (112), the first sampling sub-circuit (111) having a first even output end and a second even output end (EVEN-1T), the second sampling sub-circuit having a first odd output end and a second odd output end (ODD-1T); an input end of the first sampling sub-circuit is connected to an input end of the second sampling sub-circuit for receiving the memory command (CA); a clock end of the first sampling sub-circuit receives the even clock (PCLK-E), and a clock end of the second sampling sub-circuit receives the odd clock (PCLK-O);
the delay circuit (12) comprises a first delay sub-circuit (121) and a second delay sub-circuit (122), the first even output end being connected to an input end of the first delay sub-circuit, and the first odd output end being connected to an input end of the second delay sub-circuit;
output ends (EVEN-0T, ODD-0T) of the first delay sub-circuit and the second delay sub-circuit, and the second even output end (EVEN-1T) and the second odd output end (ODD-1T) are all connected to the command decoding circuit (13); the second even output end and the second odd output end are connected to the address output circuit (14).

7. The command sampling circuit according to claim 6, wherein the command decoding circuit (13) comprises a decoding circuit (131) and a decoding output circuit (132);
an input end of the decoding circuit is connected to the output ends of the first delay sub-circuit and the second delay sub-circuit, and the second even output end and the second odd output end, an output end of the decoding circuit is connected to the decoding output circuit, and the decoding circuit is configured to perform decoding processing;
the decoding output circuit receives the output clock and is configured to output, in response to the output edge, a decoded result currently output by the decoding circuit as the decoding information of the memory command.

8. The command sampling circuit according to claim 7, wherein the decoding circuit comprises a first decoding circuit corresponding to a 1N mode and a second decoding circuit corresponding to a 2N mode;
an input end of the first decoding circuit is connected to the second even output end (EVEN-1T) and the second odd output end (ODD-1 T), an output end of the first decoding circuit is connected to the decoding output circuit (132), and the first decoding circuit is configured to decode a received command and output a corresponding decoded result;
an input end of the second decoding circuit is connected to the output ends (EVEN-0T, ODD-0T) of the first delay sub-circuit and the second delay sub-circuit, an output end of the second decoding circuit is connected to the decoding output circuit, and the second decoding circuit is configured to decode a received command and output a corresponding decoded result;
the decoding output circuit (132) receives the output clock (PCSCLK) and outputs, in response to the output edge, a decoded result currently output by the first decoding circuit or the second decoding circuit as the decoding information of the memory command.

9. The command sampling circuit according to claim 6, wherein an input end of the address output circuit is connected to the second even output and the second odd output, a clock end of the address output circuit receives the output clock, and the address output circuit is configured to output, in response to the output edge, a current output of the second even output end or the second odd output end as the address information of the memory command.

10. The command sampling circuit according to claim 9, wherein the address output circuit (14) comprises a first output circuit (141), a second output circuit (142), and an integration circuit (143);
an input end of the first output circuit is connected to the second even output end, a clock end of the first output circuit receives the output clock, and the first output circuit is configured to output, in response to the output edge, the current output of the second even output end;
an input end of the second output circuit is connected to the second odd output end, a clock end of the second output circuit receives the output clock, and the second output circuit is configured to output, in response to the output edge, the current output of the second odd output end;
the integration circuit is coupled to the first output circuit and the second output circuit, and is configured to integrate the outputs of the first output circuit and the second output circuit and output an integrated output as the address information of the memory command.

11. The command sampling circuit according to any one of claims 1-10, further comprising: a clock generation circuit, wherein
the clock generation circuit receives the sampling clock, is coupled to the command decoding circuit and the address output circuit, and is configured to generate the output clock according to the sampling clock.

12. A memory, comprising: the command sampling circuit, the command decoding circuit, and the address output circuit according to any one of claims 1-11.
